Europäisches Patentamt

European Patent Office

Office européen des brevets

(11) Publication number: **0 348 640**
**A2**

## EUROPEAN PATENT APPLICATION

(21) Application number: 89108386.7

(51) Int. Cl.⁴: **H01L 23/28 , H01L 23/48**

(22) Date of filing: **10.05.89**

The title of the invention has been amended (Guidelines for Examination in the EPO, A-III, 7.3).

(30) Priority: **10.05.88 JP 113246/88**

(43) Date of publication of application:
**03.01.90 Bulletin 90/01**

(84) Designated Contracting States:
**DE FR GB**

(71) Applicant: **Kabushiki Kaisha Toshiba**
**72, Horikawa-cho Saiwai-ku**
**Kawasaki-shi(JP)**

(72) Inventor: **Osawa, Akihiko c/o Intellectual**
**Property Division**
**K.K. Toshiba 1-1 Shibaura 1-chome**
**Minato-ku Tokyo 105(JP)**
Inventor: **Koshino, Yutaka c/o Intellectual**
**Property Division**
**K.K. Toshiba 1-1 Shibaura 1-chome**
**Minato-ku Tokyo 105(JP)**
Inventor: **Baba, Yoshiro c/o Intellectual**
**Property Division**
**K.K. Toshiba 1-1 Shibaura 1-chome**
**Minato-ku Tokyo 105(JP)**

(74) Representative: **Lehn, Werner, Dipl.-Ing. et al**
**Hoffmann, Eitle & Partner Patentanwälte**
**Arabellastrasse 4**
**D-8000 München 81(DE)**

(54) Semiconductor device including a protective film.

(57) This invention discloses a semiconductor device including a surface protective film obtained by forming an amorphous semiconductor film (16) on a semiconductor substrate (11).

F I G. 3

## Semiconductor device

The present invention relates to a semiconductor device in which a surface protective film or a protective interlayer is formed.

As a passivation film serving as a surface protective film or a protective interlayer of a semiconductor device, a plasma SiN or SiO film is conventionally known.

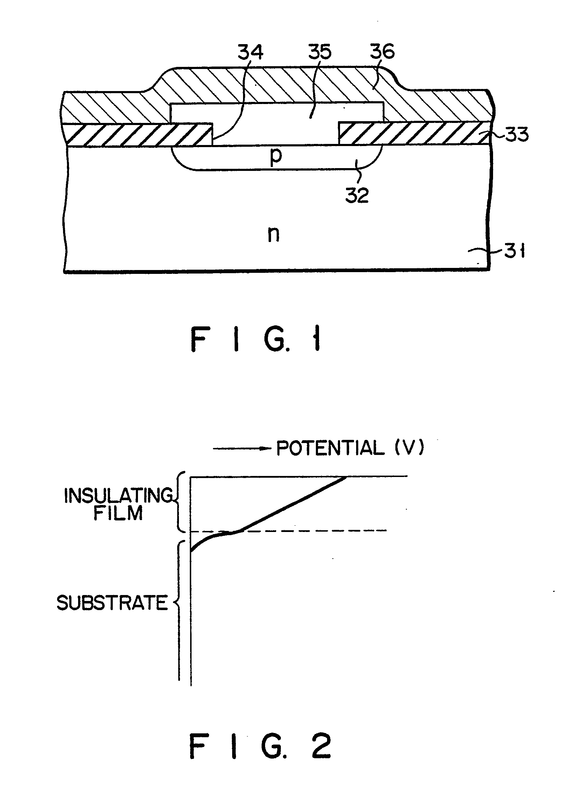

Fig. 1 is a sectional view showing an element structure of a conventional diode of a high breakdown voltage which is an example of a semiconductor device including a surface protective film. A p-type region 32 is selectively formed in a surface region of an n-type silicon substrate 31 by diffusion or the like. An SiO₂ film 33 serving as a field passivation film is formed on the surface of the substrate 31, and an opening 34 is formed in a part of the SiO₂ film 33 to expose the surface of the p-type region 32. An aluminum electrode 35 is formed in the opening 34. A passivation film 36 of, e.g., a plasma SiN or SiO film having a thickness of about 1 μm is deposited on the electrode 35.

In the conventional semiconductor device, an insulating film such as a plasma SiN or SiO film is normally used as a passivation film. However, if an external electric field is applied to this insulating film, the Laplace's equation in the insulating film of the SiO₂ film 33 and the passivation film 36 is defined as $d^2V/dx^2 = 0$, and a potential gradient is constant. More specifically, as shown in a graph in Fig. 2, since the potential in the insulating film is linearly decreased, a potential shielding effect against the external electric field of the insulating film is insufficient. For this reason, the potential adversely affects a substrate surface below the insulating film. Insufficient potential shielding adversely affects not only the substrate but also an element surface. As shown in Fig. 1, in an element with such a structure that the passivation film 36 is coated on the electrode 35, the passivation film 36 has no capability of shielding the potential. Therefore, when a bias voltage is applied to the electrode 35, a floating potential is generated on the surface of the passivation film 36 on the electrode. When this floating potential is generated, a potential difference is generated between the passivation film 36 and another electrode (not shown). Due to this potential difference, various impurity ions contained in the element, such as $Na^+$, $Ka^+$, $Cl^-$, and $OH^-$ are moved. As the ions are moved, electrons are also moved in the substrate and concentrated at the interface near a p-n junction. Therefore, deterioration of element characteristics such as a decrease in breakdown voltage of the p-n junction occurs.

In order to suppress the above influence, conventionally, the thickness of the passivation film 36 is increased, or the distance between the electrodes is increased. However, when a method of increasing the thickness of the film is employed, a crack tends to occur in the passivation film, thus degrading the reliability of the element. On the other hand, when a method of increasing the distance between the electrodes is employed, the element area is undesirably increased.

As described above, conventionally, an insulating film having an insufficient potential shielding effect is used as a surface protective film. Therefore, in order to improve the element characteristics, deterioration of the element reliability and an increase in element area may undesirably occur.

It is an object of the present invention to provide a semiconductor device which can improve element characteristics without deterioration of element reliability and an increase in element area.

A semiconductor device according to the present invention comprises a semiconductor substrate on which an elements are formed, and a surface protective film consisting of an amorphous semiconductor film formed on a semiconductor device.

Furthermore, a semiconductor device according to the present invention comprises a semiconductor substrate on which elements are formed, a multi-wiring layer formed on the surface of the substrate, and an interlayer consisting of an amorphous semiconductor film formed between the wiring layers.

In the amorphous semiconductor film used as the surface protective film on the semiconductor device or the interlayer between the wiring layers, electric charge having an amount to cancel an external electric field is generated in the amorphous semiconductor film. For this reason, even if the thickness of the amorphous semiconductor film is not much increased, relaxation of the electric field on the substrate surface can be achieved.

This invention can be more fully understood from the following detailed description when taken in conjunction with the accompanying drawings, in which:

Fig. 1 is a sectional view of a conventional semi-conductor device including a surface protective film;

Fig. 2 is a graph showing a potential profile in the semiconductor device having the surface protective film of the conventional semiconductor device, for explaining a potential shielding effect of the conventional semiconductor device shown in Fig. 1;

Fig. 3 is a sectional view of a semiconductor device including a surface protective film according to the present invention;

Fig. 4 is a graph showing a potential profile in the semiconductor device having the surface protective film of the semiconductor device according to the present invention, for explaining a potential shielding effect of the semiconductor device including the surface protective film according to the present invention shown in Fig. 3;

Figs. 5 and 6 are graphs showing relationships between the resistivity and temperatures of the surface protective film which is used in the semiconductor device according to the present invention;

Figs. 7 and 8 are graphs respectively showing a diffused Na profile and diffused heavy hydrogen profile of the surface protective films of the conventional semiconductor device including a surface protective film and the semiconductor device including a surface protective film according to the present invention;

Fig. 9 is a sectional view showing another embodiment of a semiconductor device including a surface protective film according to the present invention;

Fig. 10 is a sectional view showing still another embodiment of a semiconductor device including a surface protective film according to the present invention; and

Fig. 11 is a graph showing leak current characteristics of the conventional semiconductor device including the surface protective film shown in Fig. 1 and that of the semiconductor device including the surface protective film according to the present invention shown in Fig. 3.

Embodiments of the present invention will be described hereinafter with reference to the accompanying drawings.

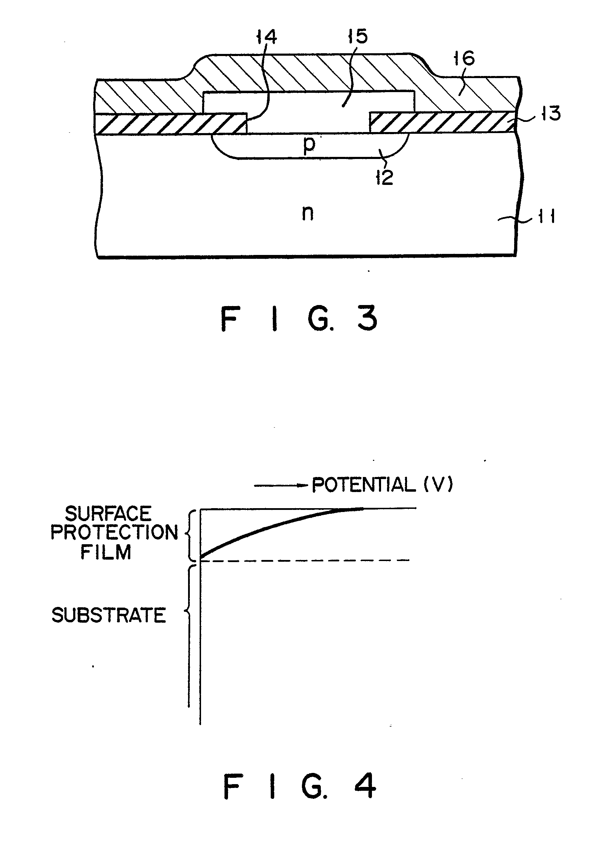

Fig. 3 is a sectional view showing an element structure when a semiconductor device including a surface protective film according to the present invention is applied to a diode having a high breakdown voltage. A p-type region 12 is selectively formed in a surface region of an n-type silicon substrate 11 by diffusion or the like. An $SiO_2$ film 13 serving as a field passivation film is formed on the surface of the substrate 11, and an opening 14 is formed in a part of the $SiO_2$ film 13 to expose the surface of the p-type region 12. An electrode 15 of, e.g., aluminum is formed in the opening 14. In addition, a surface protective film 16 consisting of an amorphous semiconductor film is formed on the electrode 15.

A plasma SiC film having a thickness of about 1 μm formed by plasma CVD (plasma chemical vapor deposition) is used as the above-mentioned surface protective film 16. The plasma SiC film is formed as follows. An $SiH_4$ (silane) gas and $C_3H_8$ -

(propan) gas are supplied in a vacuum container having a vacuum of 0.7 Torr at a flow rate of, e.g., 200 cc/min each, and the plasma SiC film is deposited at 250°c in a high-frequency discharge state of a current of 200 mA.

When an electric field is externally applied to the semiconductor device, electric charge having an amount to cancel the external electric field is generated in the surface protective film 16 consisting of an amorphous semiconductor film. Therefore, the Laplace's equation in the surface protective film 16 is defined as $d^2V/dx^2 = \rho/\epsilon$, where V is a potential in the surface protective film 16, x is a distance in a depth direction of the surface protective film 16, $\rho$ is an amount of an average electric charge excited in the surface protective film 16, and $\epsilon$ is the dielectric constant of the surface protective film 16.

For this reason, as shown in a graph in Fig. 4, the potential in the surface protective film 16 is quadratically decreased. Even if the thickness of the surface protective film 16 is not much increased, the potential in the surface protective film 16 is substantially "0" at the boundary between the surface protective film 16 and the silicon substrate 11. More specifically, the potential of the boundary between the surface protective film 16 and the silicon substrate 11 is "0", and even if the external electric field is applied, the potential does not adversely affect the substrate surface. In addition, since the surface protective film 16 has capability of shielding the potential, a potential difference between the electrodes does not tend to occur, as in the conventional case. Movement of various ions contained in the elements can be prevented, and deterioration of element characteristics such as an increase in breakdown voltage in a p-n junction is relaxed. Since the distance between the electrodes need not be increased, an increase in element area can be prevented.

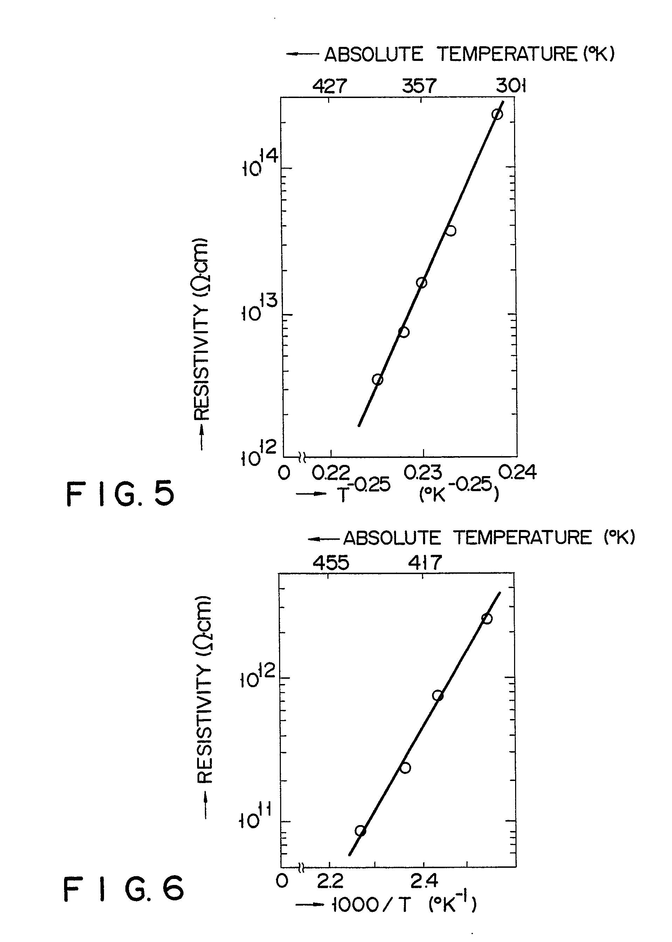

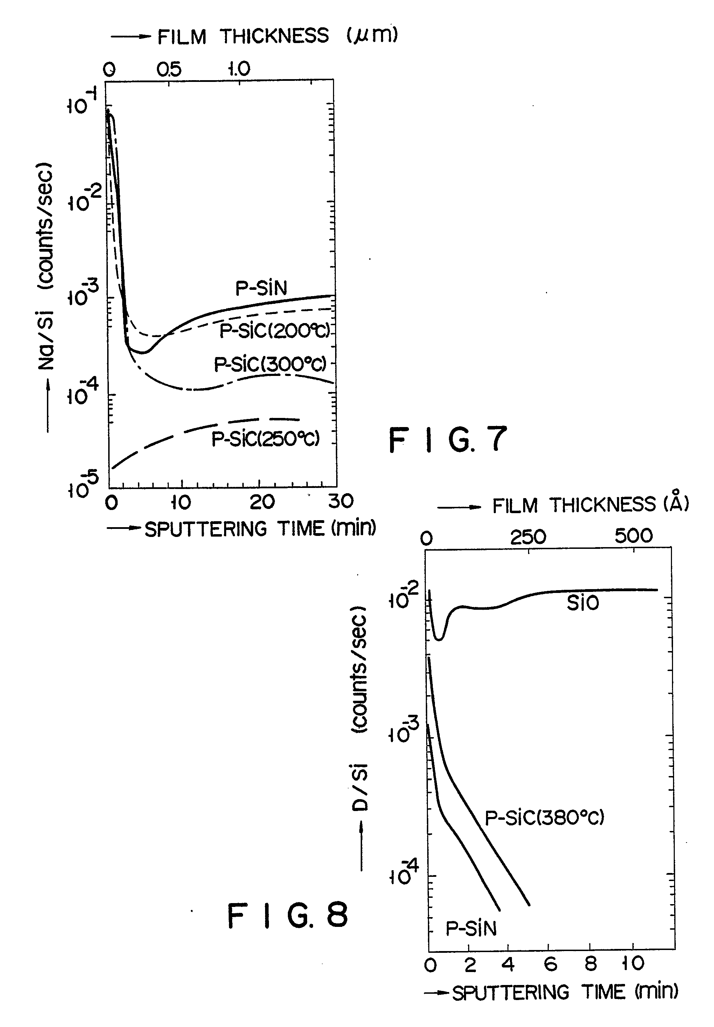

Figs. 5 and 6 are graphs showing a temperature change in resistivity ($\Omega \cdot m$) of the surface protective film 16 used in the semiconductor device of the above-mentioned embodiment. Fig. 5 shows characteristics in a low-temperature region, and Fig. 6 shows characteristics in a high-temperature region. As is apparent from Figs. 6 and 7, the surface protective film 16 has electric conduction characteristics inherent in an amorphous semiconductor film. In addition, the value of the resistivity is $10^{11}$ $\Omega \cdot m$ or more, and the surface protective film 16 has a sufficient insulation property.

Fig. 7 is a graph showing a diffused Na profile of the surface protective film 16 used in the semiconductor device of the above-mentioned embodiment, and that of a plasma SiN film used in the conventional semiconductor device. The formed films are removed by sputtering, and the numbers of Na and Si atoms obtained within unit time (1 sec) are counted. A ratio of the number of Na atoms to that of Si atoms, i.e., an Na/Si ratio (counts/sec) is calculated, so that the amount of Na contained in the original film is measured, thus determining the diffused Na profile. In Fig. 7, "P-SiN" represents a plasma SiN film used in the conventional semiconductor device, and "P-SiC" represents a plasma SiC film used in the semiconductor device according to the above-mentioned embodiment. Each value in parentheses represents a temperature when the corresponding film is deposited. As shown in Fig. 7, in the plasma SiC film deposited at $250°$ C, the amount of Na is smallest, and a sufficient anti-Na property can be obtained. On the contrary, in the plasma SiN film used in the conventional semiconductor device, the anti-Na property is degraded about 100 times the amorphous plasma SiN film used in the semiconductor device of the above embodiment.

Fig. 8 is a graph showing diffused deutrium profile of the surface protective film 16 used in the semiconductor device of the above-mentioned embodiment, and that of the plasma SiN and SiO films used in the conventional semiconductor device. The formed films are removed by sputtering, and the numbers of D (deutrium) and Si atoms obtained within unit time (1 sec) are counted. The ratio of the number of D atoms to that of Si atoms, i.e., a D/Si ratio (counts/sec) is calculated, so that the amount of deutrium contained in the original film is measured, thus determining the diffused deutrium profile. In Fig. 8, "P-SiN" represents a plasma SiN film used in the conventional semiconductor device, and "P-SiC" represents a plasma SiC film used in the semiconductor device according to the above-mentioned embodiment. Each value in parentheses represents a temperature when the corresponding film is deposited. As is understood from Fig. 7, the plasma SiC film deposited at $380°$ C has substantially the diffused deutrium profile as that of the plasma SiN film used in the conventional semiconductor device.

Thus, the plasma SiC film has a sufficient diffused Na profile and sufficient diffused deutrium profile. Therefore, the plasma SiC film can serve as a final surface protective film. In addition, the deposition rate of the plasma SiC film is higher than that of the plasma SiN film by about 25%, and the etching rate of the plasma SiC film is also higher than that of the plasma SiN film by about 20%. Therefore, the manufacturing time of the semiconductor device of the present invention can be effectively reduced, as compared with the conventional semiconductor device.

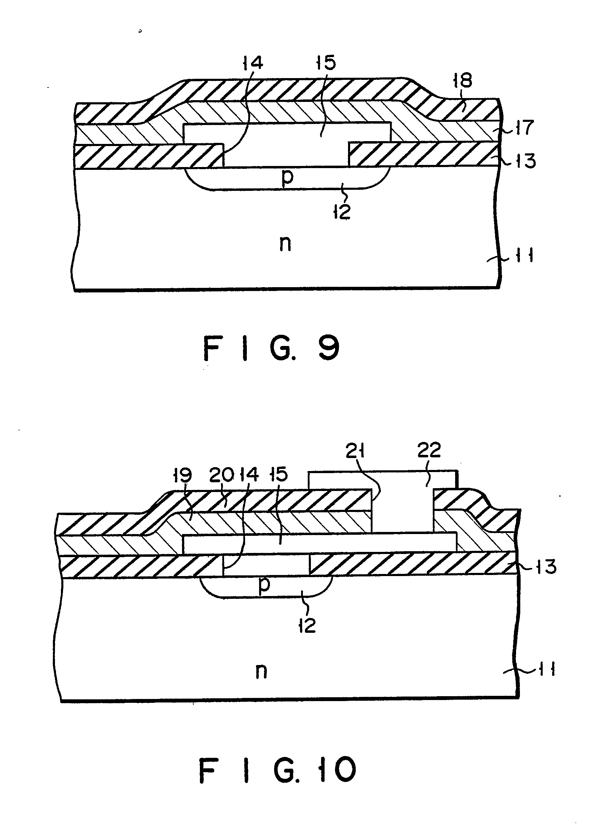

Fig. 9 is a sectional view showing a semiconductor device according to another embodiment of the present invention. In this embodiment shown in Fig. 9, the semiconductor device according to the present invention is applied to a diode having a high breakdown voltage. In this embodiment, however, a first protective film 17 consisting of an amorphous Si film which exhibits neither diffused Na profile nor diffused deutrium profile, or an amorphous semiconductor film such as a plasma SiO film having a low oxygen concentration, and which has no passivation capability, and a second protective film 18 which consists of an insulating film such as a plasma SiN or SiO film, and which has a passivation capability, are stacked on an electrode 15 of, e.g., aluminum. The amorphous Si film is formed as follows. An $SiH_4$ gas is supplied in a vacuum container having a vacuum of 1.0 Torr at a flow rate of, e.g., 200 cc/min, and the amorphous Si film is deposited at $380°$ C in a state wherein a high-frequency current of 200 mA flows between the plasma electrodes. On the other hand, the plasma SiO film having a low oxygen concentration is formed as follows. An $SiH_4$ gas and an $N_2O$ gas are supplied in a vacuum container having a vacuum of 1.0 Torr at a flow rate of, e.g., 200 cc/min, and the plasma SiO film is deposited at $380°$ C in a state wherein a high-frequency current of 200 mA flows.

With the arrangement shown in Fig. 9, a sufficient potential shielding effect can be obtained by forming the first protective film 17 of the amorphous semiconductor film, and a passivation effect such as diffused Na profile and diffused deutrium profile can be obtained by forming the second protective film 18 of the insulating film.

Fig. 10 shows a semiconductor device including a surface protective film according to still another embodiment of the present invention, and is a sectional view showing an element structure when the semiconductor device is applied to a diode having a high breakdown voltage and a multi-wiring structure. A p-type region 12 is selectively formed in a surface region of an n-type silicon substrate 11 by diffusion or the like. An $SiO_2$ film 13 serving as a field passivation film is formed on the surface of the substrate 11, and an opening 14 is formed in a part of the $SiO_2$ film 13 to expose the surface of the p-type region 12. An electrode 15 of, e.g., aluminum is formed in the opening 14. A protective film 19 consisting of an amorphous semiconductor film, e.g., a plasma SiC film is formed on the electrode 15. In addition, a protective film 20 of an insulating film such as a plasma SiN or SiO film is formed on the protective film 19. An opening 21 is formed in a part of a stacked film of the protective films 19 and 20 to expose the surface of the electrode 15. An electrode 22 of, e.g., aluminum is formed in the opening 21.

Thus, the protective film 19 consisting of the amorphous semiconductor film is used as an interlayer between the wiring layers of the semiconductor device including a multiwiring layer. Therefore, since the amorphous film is sandwiched between the electrodes 15 and 22 respectively connected to the protective films 19 and 20, the electric field can be sufficiently relaxed, thus improving reliability.

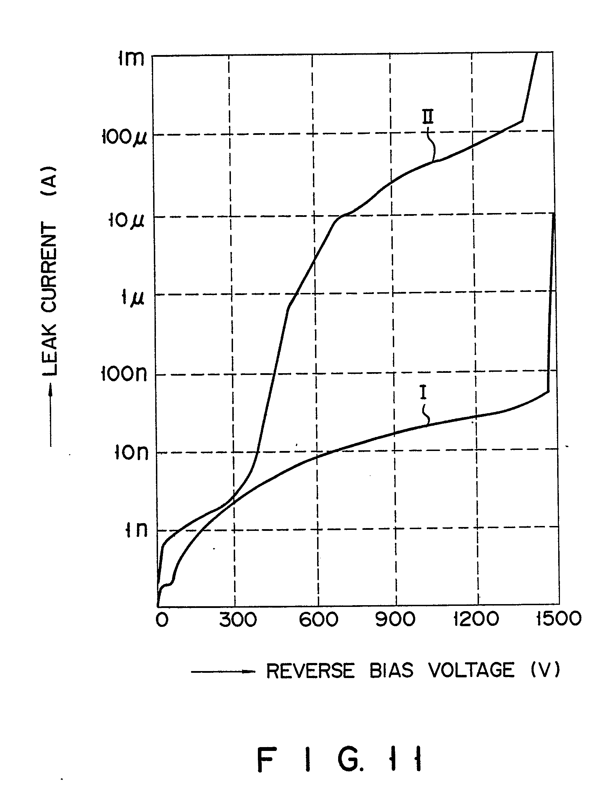

Fig. 11 is a graph showing leak current characteristics when a reverse bias voltage is applied to the p-n junction in the semiconductor device including a surface protective film according to the present invention shown in Fig. 3, and those when a reverse bias voltage is applied on the p-n junction in the conventional semiconductor device shown in Fig. 1. A characteristic curve I in Fig. 11 represents the characteristics of the semiconductor device according to the present invention shown in Fig. 3, and a characteristic curve II represents the characteristics of the conventional semiconductor device shown in Fig. 1. The characteristic curve II represents that ions adsorbed in the element surfaces are adversely affected by the electric field of the surface and approach the electrode, so that so-called "walk-out" occur. On the contrary, in the characteristic curve I of the semiconductor device according to the present invention shown in Fig. 9, the same effect as in the characteristic curve I shown in Fig. 11 can be obtained. Thus, by forming the surface protective film of the amorphous semiconductor film, an electric field of the surface can be relaxed, thus obtaining stable characteristics.

Claims

1. A semiconductor device including a surface protective film, comprising:
a semiconductor substrate (11) of a first conductivity type;
an impurity region (12) of a second conductivity type formed in a surface region of said semiconductor substrate (11);
a metal electrode (15) formed on said impurity region (12); and
an amorphous semiconductor film (16) formed on said semiconductor substrate (11) and said metal electrode (15).

2. A device according to claim 1, characterized in that said amorphous semiconductor film (16) is an amorphous plasma SiC film.

3. A device according to claim 1, characterized in that said amorphous semiconductor film (16) comprises a first protective film (17) including an amorphous Si film, and a second protective film (18) including a plasma SiN film.

4. A device according to claim 1, characterized in that said amorphous semiconductor film (16) comprises a first protective film (17) including an amorphous Si film, and a second protective film (18) including a plasma SiO film.

5. A device according to claim 1, characterized in that said amorphous semiconductor film (16) comprises a first protective film (17) including a plasma SiO film having a low oxygen concentration, and a second protective film (18) including a plasma SiN film.

6. A device according to claim 1, characterized in that said amorphous semiconductor film (16) comprises a first protective film (17) including a plasma SiO film having a low oxygen concentration, and a second protective film (18) including a plasma SiO Film.

7. A semiconductor device including a surface protective film, comprising:
a semiconductor substrate (11) of a first conductivity type;
an impurity region (12) of a second conductivity type in a surface region of said semiconductor substrate (11);
a first electrode (15) formed on said impurity region (12);
an amorphous semiconductor film (19) having an opening (21) perforated formed on said first electrode (15); and
a second electrode (22) formed over said amorphous semiconductor film (19), said second electrode (22) being connected to said first electrode (19) through said opening (21) perforated in said amorphous semiconductor film (19).

8. A device according to claim 7, characterized in that said amorphous semiconductor film (19) is an amorphous SiC film.

34  35  36

p

32

n

33

31

# F I G. 1

POTENTIAL (V)

INSULATING FILM

SUBSTRATE

# F I G. 2

F I G. 3

F I G. 4

F I G. 5

F I G. 6

FILM THICKNESS ($\mu$m)

Na/Si (counts/sec)

P-SiN

P-SiC(200°C)

P-SiC(300°C)

P-SiC(250°C)

SPUTTERING TIME (min)

F I G. 7

FILM THICKNESS (Å)

D/Si (counts/sec)

SiO

P-SiC(380°C)

P-SiN

F I G. 8

SPUTTERING TIME (min)

F I G. 9

F I G. 10

F I G. 11